# EUROPÄISCHE PATENTSCHRIFT

(11) **EP 0 817 281 B1**
(45) Veröffentlichungstag und Bekanntmachung des Hinweises auf die Patenterteilung: **15.10.2008**
(21) Anmeldenummer: 97201809.7
(22) Anmeldetag: 16.06.1997
(51) Int. Cl.: H01L 51/50, H01L 51/52

(54) **Organisches elektrolumineszentes Bauteil mit Ladungstransportschicht**
Organic electroluminescent device with an inorganic electron-conducting layer
Dispositif organique électroluminescent ayant une couche inorganique transporteuse d'électrons

(30) Priorität: 28.06.1996 DE 19625993
(43) Veröffentlichungstag der Anmeldung: 07.01.1998
(73) Patentinhaber: Philips Intellectual Property & Standards GmbH, 20099 Hamburg (DE); Koninklijke Philips Electronics N.V., 5621 BA Eindhoven (NL)
(72) Erfinder: Haase, Markus, Dr., Röntgenstrasse 24, 22335 Hamburg (DE); Kynast, Ulrich, Dr., Röntgenstrasse 24, 22335 Hamburg (DE); Boerner, Herbert, Dr., Röntgenstrasse 24, 22335 Hamburg (DE); Ronda, Cornelis, Dr., Röntgenstrasse 24, 22335 Hamburg (DE)
(74) Vertreter: Volmer, Georg

(56) Entgegenhaltungen:
- EP-A- 0 892 590
- JP-A- 5 041 285
- US-A- 5 069 815
- US-A- 5 128 587
- US-A- 5 457 565

## Beschreibung

Die Erfindung betrifft ein organisches elektrolumineszentes Bauteil, insbesondere eine Elektrolumineszenzdiode (LED) für Leuchtanzeigen, Leuchten, Festkörperbildverstärker oder Bildschirme mit einem Schichtverbund mit einer ersten Elektrodenschicht, einer anorganischen, elektronenleitenden Schicht, einer oder mehreren optoelektronisch funktionellen Schichten mit mindestens einer lichtemittierenden Schicht, die einen organischen Emitter enthält, sowie einer zweiten Elektrodenschicht.

LEDs nach dem Stand der Technik sind in der Regel anorganische Halbleiterdioden, also Dioden, deren Emittermaterial ein anorganischer Halbleiter wie dotiertes Zinksulfid, Silizium, Germanium oder III-V-Halbleiter, z.B. InP, GaAs, GaAlAs, GaP oder GaN mit entsprechenden Dotierungen ist.

Seit einigen Jahren wird an der Entwicklung von Lumineszensstrahlungsquellen gearbeitet, deren Emittermaterial kein anorganischer Halbleiter sondern ein organisches, elektrisch leitendes Material ist.

Elektrolumineszente Bauteile mit lichtemittierenden Schichten, die aus organischen Materialien aufgebaut sind, sind Lichtquellen aus anorganischen Materialien in einigen Eigenschaften deutlich überlegen. Ein Vorteil ist ihre leichte Formbarkeit und hohe Elastizität, die etwa für Leuchtanzeigen und Bildschirme neuartige Anwendungen ermöglicht. Diese Schichten können leicht als großflächige, flache und sehr dünne Schichten hergestellt werden, für die zudem der Materialeinsatz gering ist. Sie zeichnen sich auch durch eine bemerkenswert große Helligkeit bei gleichzeitig kleiner Ansteuerspannung aus.

Weiterhin kann die Farbe des emittierten Lichtes durch Wahl der lumineszierenden Substanz in weiten Bereichen von ca. 400 nm bis ca. 650 nm variiert werden. Diese Farben fallen durch ihre Luminanz auf.

Solche organischen elektrolumineszenten Bauteile können auf verschiedene Art und Weise aufgebaut sein. Allen gemeinsam ist, daß eine oder mehrere optoelektronisch funktionelle, organische Schichten, darunter die lichtemittierende, zwischen zwei Elektrodenschichten liegen, an die die zum Betrieb des Bauteils notwendige elektrische Spannung angelegt ist. Damit das emittierte Licht nach außen gelangen kann, ist mindestens eine der Elektrodenschichten transparent für sichtbares Licht. Der gesamte Schichtenverbund ist üblicherweise auf einem Substrat aufgebracht, welches ebenfalls transparent für sichtbares Licht ist, wenn das emittierte Licht aus der zum Substrat gewandten Seite austreten soll.

Für die Schichtabfolge der optoelektronisch funktionellen, organischen Schichten sind mehrere Varianten bekannt. Beispielsweise kann die lichtemittierende Schicht, bestehend aus einer dünnen Lage organischer Farbstoffmoleküle und gegebenenfalls leitfähigen organischen Polymeren, zwischen zwei weiteren elektrisch leitenden, organischen Schichten eingebettet sein, die Ladungsträger von den beiden Elektroden zu der lichtemittierenden Schicht transportieren. Die elektrisch leitende, organische Schicht zwischen der lichtemittierenden Schicht und der Kathode ist elektronenleitend, die entsprechende Schicht zwischen der lichtemittierenden Schicht und der Anode löcherleitend.

Die Verwendung solcher organischer Ladungsträger-Transportschichten ist jedoch auch mit Problemen behaftet. Die thermische Belastung der Schichten während des Betriebes sowie Materialwechselwirkungen zwischen den Elektrodenschichten und den Transportschichten führen mit der Zeit zu einer Verschlechterung der Leuchteffizienz des Bauteils. Die Lebensdauer der organischen, elektronenleitenden Schicht ist dabei besonders niedrig, insbesondere wenn zur Erzielung einer hohen Leuchteffizienz stark reduzierend wirkende Metalle wie Calcium oder Magnesium, die sich durch niedrige Austrittsarbeit für die Elektronen auszeichnen, als Kathodenmaterial verwendet werden.

In der US 5,128,587 wird daher vorgeschlagen, für die Ladungstransportschicht, die zwischen der Elektrode mit niedriger Austrittsarbeit und dem lumineszenten Film liegt und Elektronen transportiert, eine Zusammensetzung aus einem organischen oder auch anorganischen Halbleiter zu wählen. Als anorganische Halbleiter werden Ge, Si, Sn, SiC, AlSb, BN, BP, GaN, GaSb, GaAs, GaP, InSb, InAs, InP, CdSe, CdTe, ZnO, ZnS oder ZnSe vorgeschlagen. Die halbleitende Schicht kann amorph oder kristallin sein, sie kann aus einem dotierten Halbleiter vom n-Typ oder ein Eigenhalbleiter sein.

Weiterhin ist aus JP5041285 A ein Elektrolumineszenzelement bekannt, das eine Ladungstransportschicht aus einem anorganischen Halbleiter, der durch ein Sol-Gel-Verfahren hergestellt ist, auf einem mit ITO beschichtetem Glass-Substrat, sowie eine organische lumineszente Schicht und eine Kathode enthält. Wenn die organische lumineszente Schicht ein elektronentransportierendes Material ist, wird eine löchertransportierende
Schicht mit der Transportschicht kombiniert und wenn die lumineszente Schicht eine löchertransportierende Schicht ist, wird eine elektronentransportierende Schicht mit der Transportschicht kombiniert.

Ein Nachteil eines Bauteiles mit einer Ladungstransportschicht mit einem anorganischen Halbleiter der genannten Art ist es, daß die Schicht Licht im sichtbaren Bereich absorbiert.

Es ist deshalb die Aufgabe der Erfindung, ein organisches, elektrolumineszierendes Bauteil mit verbesserten Eigenschaften zur Verfügung zu stellen.

Erfindungsgemäß wird die Aufgabe durch ein organisches elektrolumineszentes Bauteil mit einem Schichtverbund mit einer ersten Elektrodenschicht, einer anorganischen, elektronenleitenden Schicht, die ein n- leitendes Oxid eines Übergangsmetalls, ausgewählt aus der Gruppe Zirkoniumoxid, Hafniumoxid, Vanadiniumoxid, Bariumtitanat, Barium-Strontiumtitanat, Strontiumtitanat, Calciumtitanat, Calciumzirkonat, Kaliumtantalat und Kaliumniobat enthält, einer oder mehreren optoelektronisch funktionellen Schichten mit mindestens einer lichtemittierenden Schicht, die einen organischen Emitter, der ein Seltenerdmetallkomplex mit einem Liganden mit einer Carboxylat- oder einer Phosphonatgruppe ist, enthält, und einer zweiten Elektrodenschicht gelöst, wobei sich die anorganische, elektronenleitende Schicht zwischen der Elektrodenschicht, welche als Kathode fungiert und der einen oder mehreren optoelektronisch funktionellen Schicht befindet und wobei der Seltenerdmetallkomplex auf der Oberfläche der elektronenleitenden Schicht verankert wird, gelöst.

Derartige anorganische, elektronenleitende Schichten besitzen eine hohe thermische und chemische Stabilität und bilden einen sehr guten elektronischen Kontakt zu den Emittermolekülen. Sie können mit keramischen Oberflächen definierter Rauhigkeit erzeugt werden, die es erlauben, mehr Emittermoleküle aufzubringen und so die aktive Oberfläche zu vergrößern. Die Oxide absorbieren kein Licht im sichtbaren Bereich und sind in dünnen Schichten transparent.

Im Rahmen der vorliegenden Erfindung ist es bevorzugt, daß das n-leitende Oxid, ausgewählt aus der Gruppe Zirkoniumoxid, Hafniumoxid, Vanadiumoxid, Bariumtitanat, Barium-Strontiumtitanat, Strontiumtitanat, Calciumtitanat, Calciumzirkonat, Kaliumtantalat und Kaliumniobat, ein dotiertes Oxid ist

Es kann auch bevorzugt sein, daß das Oxid des Übergangsmetalls niobdotiertes Strontiumtitanat SrTiO₃ ist. Niobdotiertes Strontiumtitanat SrTiO₃ ist besonders photoaktiv.

Es kann auch bevorzugt sein, daß der organische Emitter ein Seltenerdmetallkomplex mit einem Liganden mit einer Carboxylat- oder einer Phosphonatgruppe ist.

Durch diesen Liganden wird der lichtemittierende Komplex auf die Oxidoberfläche aufgepfropft (grafting). Er bildet eine Verkettung (interlocking group) zwischen dem Seltenerdmetallion und der Ladungstransportschicht, die eine enge elektronische Kopplung zwischen beiden bewirkt.

Die Bindung der Emittermoleküle an die Oxidschichten, die einen hohen Brechungsindex haben, verringert darüber hinaus die Lebensdauer des angeregten Zustandes des Emittermoleküles und damit die Fluoreszenzabklingzeit. Dies ist für Displayanwendungen von Vorteil, weil das störende Nachleuchten bei bewegten Objekten im Bild (Kometeneffekt) entfällt.

Nachfolgend wird die Erfindung anhand von Figuren und Ausführungsbeispielen weiter erläutert.
**Fig. 1** zeigt den prinzipiellen Aufbau eines organischen elektrolumineszenten Bauteils nach der Erfindung mit einer Drei-Schicht-Anordnung
**Fig. 2**: zeigt eine andere Ausführungsform der Erfindung mit einer Zwei-Schicht-Anordnung

Das erfindungsgemäße organische elektrolumineszente Bauteil enthält einen Schichtverbund aus einer ersten Elektrodenschicht (Kathode), einer anorganischen, elektronenleitenden Schicht **1**, einer oder mehreren optoelektronisch funktionellen Schichten mit mindestens einer lichtemittierenden Schicht, die einen organischen Emitter enthält **4** und einer zweiten Elektrode (Anode).

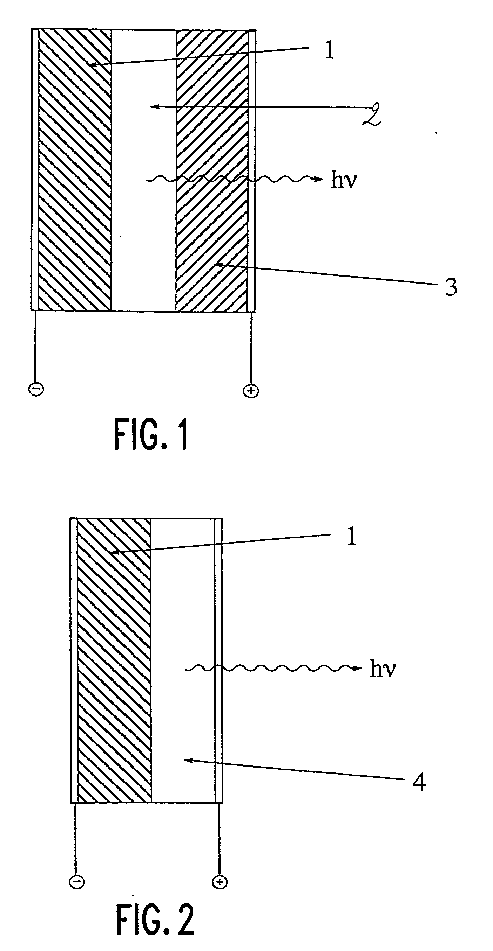

Diese Zwei-Schicht-Anordnung ist in **Fig. 2** dargestellt. Es ist aber auch eine Drei-Schicht-Anordnung gemäß **Fig. 1** möglich, bei der der Schichtaufbau eine weitere, löcherleitende Ladungstransport-Schicht **3** zwischen den optoelektronisch funktionellen Schichten **2** und der Anode umfaßt.

Die Kathode besteht im allgemeinen aus einem Metall oder einer Legierung mit niedriger Austrittsarbeit, z.B. Mg, MgAg, Li, Al, Na, K, Ca, Rb, Sr, Ce, Seltenerdmetalle sowie deren antimon- oder indiumhaltigen Legierungen.

Die anorganische, elektronenleitende Schicht enthält ein Oxid eines Übergangsmetalls, ausgewählt aus der Gruppe Zirkoniumoxid ZrO₂, Hafniumoxid HfO₂, Vanadiumoxid V₂O₅, Bariumtitanat BaTiO₃, Barium-Strontiumtitanat (Ba,Sr)TiO₃, Strontiumtitanat SrTiO₃, Calciumtitanat CaTiO₃, Calciumzirkonat CaZrO₃, Kalium-tantalat KTaO₃ und Kaliumniobat KNbO₃.
Die Erzeugung der n-Leitung in den Oxiden kann beispielsweise durch entsprechende Dotierung, durch thermische Nachbehandlung in inerter oder reduzierender Atmosphäre oder durch eine Kombination dieser Maßnahmen erreicht werden

Die anorganische, elektronenleitende Schicht kann eine Schicht keramischer Art sein, d.h. eine Schicht, die aus Primärteilchen hergestellt und anschließend gesintert wird. Sie kann auch nanokristalliner Art sein, aus sehr kleinen Primärteilchen bestehen, die eine Teilchengröße zwichen 1 und 100 nm haben und ein poröses Netzwerk bilden. Nanokristalline Schichten können beispielsweise durch ein Sol-Gel-Verfahren hergestellt werden. Die Schicht kann auch amorph, kolloidal oder mikrokristallin sein und durch eine Vakuum-Abscheidetechnik wie Verdampfen, PCVD, MOCVD etc. hergestellt werden. Schichtdicken von weniger als 100 nm bis zu einer oberen Grenze von etwa 5mm sind je nach Herstellungstechnik und Leitfähigkeit des oxidischen Materials möglich.

Für die Abfolge der optoelektronisch funktionellen Schichten sind mehrere Varianten möglich. Beispielsweise kann sie nur eine einzige organische Schicht umfassen. Diese kann aus einem leitfähigen organischen Polymer bestehen, welches selber zur Lichtemission fähig ist. Sie kann aber auch aus einem oder mehreren leitfähigen organischen Polymeren und einem oder mehreren organischen Farbstoffverbindungen bestehen, wobei in der Schicht die Polymeren und die Farbstoffverbindungen entweder physikalisch gemischt oder chemisch gebunden sein können.

Die optoelektronisch funktionellen Schichten können als organischen Emitter einen oder mehrere metallo-organische Komplexe von Seltenerdmetallen mit organischen Sauerstoff-, Schwefel- oder Stickstoff-Liganden enthalten. Unter metallo-organischen Komplexen sollen im Rahmen der vorliegenden Erfindung solche Komplexe mit den genannten organischen Liganden verstanden werden, bei denen die Bindung über die Heteroatome erfolgt. Je nach gewünschter Farbe des emittierten Lichtes können auch mehrere Seltenerdmetallkomplexe verwendet werden. Es können auch Seltenerdmetallkomplexe verwendet werden, die nicht sublimierbar oder nicht elektrisch leitend sind.

Das Seltenerdmetallion kann beispielsweise Eu²⁺, Eu³⁺, Tb³⁺, Tm³⁺, Dy³⁺, Sm³⁺, oder Pr³⁺ sein.

Mit Europium- und Samariumkomplexen kann rote, mit den Terbiumkomplexen grüne und mit den Thulium- und Dysprosiumkomplexen blaue Fluoreszenz erzeugt werden.

Besonders geeignet sind Seltenerdmetallkkomplexe der allgemeinen Zusammensetzung SE[L₁]₃[L₂]ₙ. Hierin ist SE ein dreiwertiges Seltenerdmetall-Kation, L₁ ein anionischer Ligand, der ein- oder zweizähnig sein kann, und L₂ ein neutraler Ligand, der ein- oder zweizähnig sein kann. n wird so gewählt, daß alle Koordinationsstellen des Seltenerdions abgesättigt sind, n kann somit die Werte 0,1,2,3 und 4 einnehmen. L₁ und L₂ sind immer zwei unterschiedliche Liganden. Für Eu²⁺ lautet die entsprechende Formel Eu[L₁]₂[L₂]ₙ.

Als Ligand L₁ sind besonders die beta- Diketonate R₁C(OH)CHCOR₂ geeignet. Die Reste R₁ und R₂ können ein F₃C-, Thenoyl C₄H₃S-, Furanoyl C₄H₃O-, t-Butyl und Perfluor-n-propyl C₃F₇- sein. Wenn R₁ und R₂ ein CF₃-Rest sind, erhält man das beta-Diketonat Hexafluoracetyl-acetonat (hfa). Wenn R₁ und R₂ ein t-butyl-Rest sind, erhält man das beta- Diketonat 2,2,6,6,-tetrametyl-3,5-heptandion (thd). Wenn R₁ ein Thenoylrest und R₂ ein CF₃ -Rest ist, erhält man das Betadiketon Thenoyltrifluoroacetylacetonat (ttfa). Wenn R₁ ein Furanoylrest und R₂ ein CF₃ -Rest ist, erhält man das Betadiketon Furanolyltri-fluoroacetylacetonat (ftfa). Wenn R₁ ein t-Butylrest und R₂ ein Perfluor-n-propyl-Rest ist, erhält man das Betadiketon 7,7-Dimethyl-1,1,1,2,2,3,3-heptafluor-4,6-octandion (FOD). Ein weiteres Beta-diketon, das als Ligand geeignet ist, ist 3-(Trifluormethyl-hydroxymethylen)-1-campher.

Besonders effizient sind die Chelatkomplexe der Seltenerdmetalle mit Liganden L₁, die Anionen aromatischer Carbonsäuren, wie Benzoesäure, Dipicolinsäure und Picolinsäure sind.

Die Liganden L₂ sind neutrale Liganden, die ein oder mehrzähnig sein können. Die einzähnigen Liganden können Pyridin und dessen Derivate, Trialkyl-, Alkylphenyl- und Triphenylphosphinoxide, Dialkyl-, Alkylphenyl- und Diphenylsulfoxide, Alkyl-, Alkylphenyl- und Phenylamine sowie Alkyl-, Alkylphenyl- und Phenylphosphate sein.

Als mehrzähnige Liganden sind 2,2'Bipyridin, 2,2',6,2''Terpyridin, 1,10 Phenantrolin und N,N,N',N'-Tetramethylethylendiamin und deren Derivate geeignet.

Besonders geeignet sind als Liganden L₂ auch solche mit einer Phosphonat- oder Carboxylatgruppe, beispielsweise phosphonierte oder carboxylierte Polypyridyl-Liganden( phosphonated or carboxylated polypyridyl ligands) wie 2,2':6'2''-terpyridine-4'-Phosphonat (4'-Po₃H₂-terpy) oder 2,2'-bipyridyl-4,4'-dicarboxylat. Diese Liganden bilden gleichzeitig mit den Seltenerdmetallionen einen lichtemittierenden Chelatkomplex und andererseits sind sie über die Phosphonat- oder Carboxylatgruppe an dem Oxid der elektronenleitenden Schicht absorbiert. Dadurch werden die Seltenerdmetallkomplexe auf der Oberfläche der elektronenleitenden Schicht verankert. Der adsorbierte Komplex wirkt als Ladungstransport-Sensibilizierer (charge transfer sensitizer) und der Elektronenübergang von dem Leitungsband des Oxids in den angeregten Zustand des organischen Emitters erfolgt ultraschnell und mit hoher Quantenausbeute.

Als Material für die Anode, von der aus Löcher in die optoelektronisch funktionellen Schichten injiziert werden, sind Metalle, Metalloxide oder elektrisch leitende organische Polymere mit hoher Austrittsarbeit für Elektronen geeignet. Beispiele sind dünne, transparente Schichten aus indiumdotiertem Zinnoxid (ITO), Gold oder Polyanilin.

Damit das emittierte Licht nach außen gelangen kann, ist mindestens eine der Elektroden, üblicherweise die Anode, transparent für sichtbares Licht. Der gesamte Schichtverbund ist auf einem Substrat aufgebracht, welches ebenfalls transparent für sichtbares Licht sein muß, wenn das emittierte Licht aus der zum Substrat gewandten Seite austreten soll.

Bei einem derartigen Aufbau des elektrolumineszenten organischen Bauteils mit einer Schicht zwischen der Kathode und den optoelektronisch funktionellen Schichten, deren Matrial elektronenleitend, aber nicht oder kaum löcherleitend ist, können die Elektronen von der Kathode nur bis zu der optoelektronisch funktionellen Schicht, nicht aber zu der Anode gelangen. Umgekehrt können Löcher aus der Anode nur die optoelektronisch funktionellen Schicht, nicht die Kathode erreichen. Durch diesen Ladungsträgereinschluss (charge carrier confinement) bleiben die Verlustströme durch das Bauteil gering und die optoelektronisch Effizienz des Bauteils wird höher, weil zwangsläufig viele Ladungsträger in der Nähe der optoelektronisch funktionellen Schicht bleiben und deshalb ihre Energie auf den Emitter übertragen.

Das erfindungsgemäße Bauteil weist außerdem eine ausgeglichene Ladungsträgerbilanz auf. Da die Injektion von Elektronen und Löchern aus der Kathode bzw. der Anode sehr unterschiedliche Effizienz haben kann, kann das Verhältnis von Elektronen zu Löchern in der optoelektronisch funktionellen Schicht bei Bauteilen ohne sperrende Transportschichten sehr deutlich vom idealen Wert 1 verschieden sein. Da der Energieübertrag auf die Leuchtzentren in der optoelektronisch funktionellen Schicht auf der paarweisen Rekombination von Elektronen und Löchern beruht, reduziert dies die Effizienz des Bauteils. Bei den Bauteilen nach der Erfindung bleiben die überschüssigen Ladungsträger an der entsprechen Grenzschicht der optofunktionellen Schicht eingeschlossen und erzeugen entsprechend ihrer Ladung eine Raumladungszone, die die Injektion der umgekehrt geladenen unterschüssigen Ladungsträger verstärkt. Auf diese Art und Weise ist das Verhältnis der Ladungsträger in dem erfindungsgemäßen Bauteil ausgeglichener und die Effizienz des Bauteils erhöht.

### Ausführungsbeispiel 1:

200 g SrCO₃, 110 g TiO₂ und 540,2 mg Nb₂O₅ werden mit destilliertem Wasser vermengt und 24 Stunden nassgemahlen. Die erhaltene Suspension wird getrocknet und das erhaltene Pulver 4 Stunden bei 1100°C calciniert. Anschließend wird das calcinierte Pulver bei 5 Tonnen Druck in 2-3 mm dicke Scheiben von 10 mm Durchmesser gepreßt. Die Scheiben werden dann bei 1200°C für 2 Stunden an Luft und anschließend für 4 Stunden bei 1350°C gesintert. Während der Abkühlphase nach dem letzten Heizschritt wird zur Reduktion Stickstoff/Wasserstoff im 3:1 Gemisch über die Scheiben geleitet. Die Abkühlungsgeschwindigkeit wird dabei bei 7°C min⁻¹ konstant gehalten. Schließlich wird jeweils eine Seite der Scheiben im Vakuum mit Indium-Metall bedampft (kontaktiert) (Sundaram, S.K.; J. Mater. Sci. Mater. Electron. 5 (1994) 344-346).
Eine Lösung von 2,5 Gew.- % Poly(vinylcarbazol) und 0,1 Gew.- % Eu(Ttfa)₃phen (Eu = Europium; Ttfa = 1-(2-Thienyl)-4,4,4-trifluor-1,3-butandion, phen =1,10-Phenanthrolin) in THF werden durch ein Schleuderverfahren aus der Lösung auf die nicht-kontaktierte Scheibenseite aufgebracht. Ein dünner, transparenter Gold-Film wird als Anode aufgedampft. Die Leuchtdiode zeigt rote Fluoreszenz.

### Ausführungsbeispiel 2:

Auf ein unbeschichtetes, kontaktiertes n-Strontiumtitanatsubstrat nach Ausführungsbeispiel 1 wird eine Lösung aus 2,5 Gew.-% Polyvinylcarbazol und 0,01 Gew.-% Coumarin-6 (Laserfarbstoff, Lambada-Physics) in einem 1:1-Gemisch von THF und 1,1,1-Trichloraethan durch ein Schleuderverfahren aufgebracht. Ein dünner transparenter Gold-Film wird als Anode aufgedampft. Die Leuchtdiode zeigt grüne Fluoreszenz.

## Patentansprüche

1. Organisches elektrolumineszentes Bauteil mit einem Schichtverbund mit
a) einer ersten Elektrodenschicht,
b) einer anorganischen, elektronenleitenden Schicht (1), die ein n-leitendes Oxid eines Übergangsmetalls, ausgewählt aus der Gruppe Zirkoniumoxid, Hafniumoxid, Vanadiumoxid, Bariumtitanat, Barium-Strontiumtitanat, Strontiumtitanat, Calciumtitanat, Calciumzirkonat, Kaliumtantalat und Kaliumniobat, enthält,
c) einer oder mehreren optoelektronisch funktionellen Schichten (2) mit mindestens einer lichtemittierenden Schicht, die einen organischen Emitter, der ein Seltenerdmetallkomplex mit einem Liganden mit einer Carboxylat- oder einer Phosphonatgruppe ist, enthält, und
d) einer zweiten Elektrodensohicht
wobei sich die anorganische, elektronenleitende Schicht zwischen der Elektrodenschicht, welche als Kathode fungiert und der einen oder mehreren optoelektronisch funktionellen Schicht befindet und wobei der Seltenerdmetallkomplex auf der Oberfläche der elektronenleitenden Schicht verankert wird.

2. Organisches elektrolumineszentes Bauteil gemäß Anspruch 1,
**dadurch gekennzeichnet,**
**dass** das n-leitende Oxid, ausgewählt aus der Gruppe Zirkoniumoxid, Hafniumoxid, Vanadiumoxid, Bariumtitanat, Barium-Strontiumtitanat, Strontiumtitanat, Calciumtitanat, Calciumzirkonat, Kaliumtantalat und Kaliumniobat, ein dotiertes Oxid ist.

3. Organisches elektrolumineszentes Bauteil gemäß Anspruch 1,
**dadurch gekennzeichnet,**
**dass** das Oxid des Übergangsmetalls niobdotiertes Strontiumtitanat SrTiO₃ ist.

## Claims

1. An organic electroluminescent module having a layer combination of
a) a first electrode layer,
b) an anorganic, electron conductive layer (1) which comprises an n-conductive oxide of a transition metal, selected from the group of zirconium oxide, hafnium oxide, vanadium oxide, barium titanate, barium strontium titanate, strontium titanate, calcium titanate, calcium zirconate, potassium tantalate and potassium niobate,
c) one or a plurality of optoelectronically functional layers (2) with at least one light-emitting layer which comprises an organic emitter, which is a rare earth metal complex with a ligand with a carboxylate or a phosphonate group, and
d) a second electron layer,
where the anorganic, electron conductive layer is disposed between the electron layer that functions as a cathode and the one or more layers that function optoelectronically and
where the rare earth metal complex is embedded on the surface of the electron conductive layer.

2. An organic electroluminescent module as claimed in claim 1, **characterized in that** the n-conductive oxide, selected from the group of zirconium oxide, hafnium oxide, vanadium oxide, barium titanate, barium strontium titanate, strontium titanate, calcium titanate, calcium zirconate, potassium tantalate and potassium niobate is a doped oxide.

3. An organic electroluminescent module as claimed in claim 1, **characterized in that** the oxide of the transition metal is niobium doped strontium titanate SrTiO₃.

## Revendications

1. Composant électroluminescent organique avec une structure en couches composée
a) d'une première couche d'électrodes,
b) d'une couche (1) inorganique conductrice d'électrons qui contient un oxyde n-conducteur d'un métal de transition, sélectionné dans le groupe de l'oxyde de zirconium, de l'oxyde d'hafnium, de l'oxyde de vanadium, du titanate de baryum, du titanate de baryum-strontium, du titanate de strontium, du titane de calcium, du zirconate de calcium, du tantalate de potassium et du niobate de potassium,
c) d'une ou plusieurs couches (2) fonctionnelles optoélectroniquement d'au moins une couche émettrice de lumière qui contient un émetteur organique, qui est un complexe métallique de terre rare avec un ligand doté d'un groupe carboxylate ou phosphonate, et
d) d'une deuxième couche d'électrodes,
dans lequel la couche inorganique conductrice d'électrons se trouve entre la couche d'électrodes qui tient lieu de cathode et les une ou plusieurs couches fonctionnelles optoélectroniquement et le complexe de métaux de terres rares étant ancré à la surface de la couche conductrice d'électrons.

2. Composant électroluminescent organique selon la revendication 1,
**caractérisé en ce**
**que** l'oxyde n-conducteur sélectionné dans le groupe de l'oxyde de zirconium, de l'oxyde d'hafnium, de l'oxyde de vanadium, du titanate de baryum, du titanate de baryum-strontium, du titanate de strontium, du titanate de calcium, du zirconate de calcium, du tantalate de potassium et du niobate de potassium est un oxyde dopé.

3. Composant électroluminescent organique selon la revendication 1,
**caractérisé en ce**
**que** l'oxyde du métal de transition est du titanate de strontium SrTiO₃ dopé au niobium.
